Europäisches Patentamt

European Patent Office

Office européen des brevets

(11) Veröffentlichungsnummer: **0 115 319**
**A2**

## (12) EUROPÄISCHE PATENTANMELDUNG

(21) Anmeldenummer: **84100689.3**

(22) Anmeldetag: **24.01.84**

(51) Int. Cl.³: **H 04 B 1/66**

(30) Priorität: 29.01.83 DE 3303006
29.01.83 DE 3303007

(43) Veröffentlichungstag der Anmeldung:
08.08.84 Patentblatt 84/32

(84) Benannte Vertragsstaaten:
AT DE FR GB IT SE

(71) Anmelder: International Standard Electric Corporation
320 Park Avenue
New York New York 10022(US)

(84) Benannte Vertragsstaaten:
FR GB IT SE AT

(71) Anmelder: Standard Elektrik Lorenz Aktiengesellschaft
Hellmuth-Hirth-Strasse 42
D-7000 Stuttgart 40(DE)

(84) Benannte Vertragsstaaten:
DE

(72) Erfinder: Gassmann, Gerhard-Günter
Thomasäckerweg 5
D-7300 Esslingen(DE)

(72) Erfinder: Bertsch, Günter
Mühlhaldenweg 51
D-7310 Plochingen(DE)

(72) Erfinder: Köhler, Günter
Bussardweg 7
D-7312 Kirchheim/Teck(DE)

(74) Vertreter: Villinger, Bernhard, Dipl.-Ing. et al,
Standard Elektrik Lorenz AG Patent- und Lizenzwesen
Postfach 300 929 Kurze Strasse 8
D-7000 Stuttgart 30(DE)

(54) **System zur Übertragung und/oder Speicherung von Analogwerten.**

(57) Die zu übertragenden oder zu speichernden Analogwerte werden mit hoher Auflösung in digitale Datenwörter umgesetzt. Jedes digitale Datenwort wird in zwei oder mehr Bitgruppen zerlegt. Jede Bitgruppe wird in einen Analogwert gewandelt, der übertragen oder gespeichert wird.

Die Bandbreite ist deutlich geringer als bei (gleich schneller) rein digitaler Übertragung. Durch Beschränkung auf weniger Amplitudenstufen ist eine fehlerfreie Übertragung möglich.

Fig.1

G.G.Gassmann-G.Bertsch-G.Köhler I 113/112-10/9-2/1

System zur Übertragung und/oder Speicherung
von Analogwerten

Die Erfindung betrifft ein System zur Übertragung und/
oder Speicherung von Analogwerten mindestens bestehend
aus einem Eingangsteil, einer Übertragungsstrecke oder
einem Speichermedium für Analogsignale (beispielsweise
einem Ton- oder Videobandgerät) und einem Ausgangsteil,
wobei im Eingangsteil ein Analog-Digital-Wandler vorhanden
ist, der jeden Analogwert in ein n-stelliges digitales
Datenwort wandelt und wobei im Ausgangsteil ein Digital-
Analog-Wandler vorhanden ist, der die n-stelligen digitalen Datenwörter in Analogwerte rückwandelt.

Die meß- oder nachrichtentechnische Verarbeitung von Analogwerten kann sowohl in Analogtechnik, wie auch in Digitaltechnik erfolgen. (Ein stetiges Analogsignal ist eine
kontinuierliche Folge einzelner Analogwerte und fällt
deshalb auch unter diesen Begriff). Bei geringen Qualitätsanforderungen ist die Verarbeitung von Analogwerten,
insbesondere deren Übertragung oder Speicherung, verhältnismäßig problemlos. Auch bei hohen Qualitätsanforderungen, etwa für High-Fidelity-Qualität im Tonbereich,

ZT/P2-Bs/Gn
12.12.1983

0115319

G.G.Gassmann 113/112-10/9-2/1

wird weitgehend Analogtechnik eingesetzt. Dabei muß jedoch
ein recht hoher Aufwand betrieben werden (eng tolerierte,
gealterte Bauteile, Schaltungsmaßnahmen zum Ausgleich etwa von Temperaturschwankungen, exakte Justierung). Die
Grenzen der Analogtechnik werden dort erreicht, wo eine
Vielzahl von Verarbeitungsschritten aufeinander folgt
(Übertragung, Mischung, Speicherung, Kopieren). Dies
wird z.B. deutlich bei der sogenannten digitalen Schallplatte, die als solche gar nicht digital ist, deren hohe
Wiedergabequelität aber dadurch erreicht wird, daß die
Zwischenschritte bei der Verarbeitung in Digitaltechnik
erfolgen. Bei der analogen Verarbeitung ergeben sich
immer irgendwelche Fehler, etwa durch Rauschen, die
prinzipiell nicht korrigiert werden können und die sich
immer weiter aufsummieren. Bei der Verarbeitung von Analogwerten in Digitaltechnik ergeben sich Fehler im analogen Eingangsteil und durch die Quantisierung sowie im
analogen Ausgangsteil; im Digitalteil, und mag er noch
so viele Zwischenstufen aufweisen, ergeben sich Fehler
nur in sehr geringem Ausmaß und selbst diese können wieder weitgehend korrigiert werden.

Die Digitaltechnik hat jedoch gegenüber der Analogtechnik
den Nachteil, daß bei der Übertragung große Bandbreiten
und bei der Speicherung große Speicherkapazitäten erforderlich sind.

Der Erfindung liegt die Aufgabe zugrunde, ein System anzugeben, mit dem die Übertragung oder Speicherung von
Analogwerten so fehlerfrei und mit geringem schaltungstechnischem Aufwand möglich ist wie bei der Digitaltechnik, bei dem aber der Bedarf an Übertragungsbandbreite
bzw. Speicherkapazität gegenüber dem bei der Dititaltech-

G.G.Gassmann 113/112-10/9-2/1

nik deutlich reduziert ist.

Die Aufgabe wird erfindungsgemäß gelöst durch die kennzeichnenden Merkmale des Anspruchs 1. Vorteilhafte Ausgestaltungen der Erfindung sind den Unteransprüchen
2 bis 9 zu entnehmen.

Für den Fall, daß die nacheinander zu übertragenden
oder zu speichernden Analogwerte aufeinanderfolgende
Abtastwerte eines Tonsignals sind, kann der Bedarf an
Übertragungsbandbreite bzw. Speicherkapazität durch die
in den Ansprüchen 10 und 11 genannten Merkmale weiter
deutlich verringert werden. Dieser Einsparungsmöglichkeit liegt folgende Erkenntnis zugrunde:

Das menschliche Ohr ist in einem großen Lautstärkebereich
wahrnehmungsfähig. Es kann sich jedoch nicht beliebig
schnell an die jeweils herrschende Lautstärke anpassen.
In Zeitabschnitten, die kürzer sind, als die vom Ohr benötigte Anpassungszeit, kann der wiedergebbare Lautstärkebereich eingeengt sein. Es genügt deshalb eine Übertragung
oder Speicherung von Tonintervallen, die kürzer sind als
ein solcher Zeitabschnitt und die nur einen eingeengten
Lautstärkebereich umfassen. Wird, wie üblich, der Amplitudenverlauf durch Angabe einzelner Amplitudenwerte beschrieben, und wird jeder Amplitudenwert durch eine aus Exponent
und Mantisse bestehende Digitalzahl beschrieben, so genügt es, innerhalb eines kurzen Abschnitts alle Digitalzahlen mit demselben Exponenten auszudrücken, so daß bei
vorgegebener Stellenzahl der Mantissen kleinere Amplidudenwerte zu Null werden. Dabei ist der dem größten Amplitudenwert entsprechende Exponent zu wählen. Es genügt
deshalb für einen solchen Zeitabschnitt die Angabe eines

G.G.Gassmann 113/112-10/9-2/1

einzigen Exponenten, d.h. des jeweiligen Lautstärkebereichs; die einzelnen Mantissen stehen dann für die
einzelnen Amplitudenwerte innerhalb dieses Bereichs.

Anspruch 12 nennt eine vorteilhafte Einsatzmöglichkeit
eines erfindungsgemäßen Systems.

Im folgenden wird die Erfindung anhand von Ausführungsbeispielen unter Zuhilfenahme der beiliegenden Zeichnung
weiter erläutert.

Fig. 1   zeigt als Ausführungsbeispiel das Blockschalt-
         bild eines Eingangsteils und eines Ausgangs-
         teils eines erfindungsgemäßen Systems.

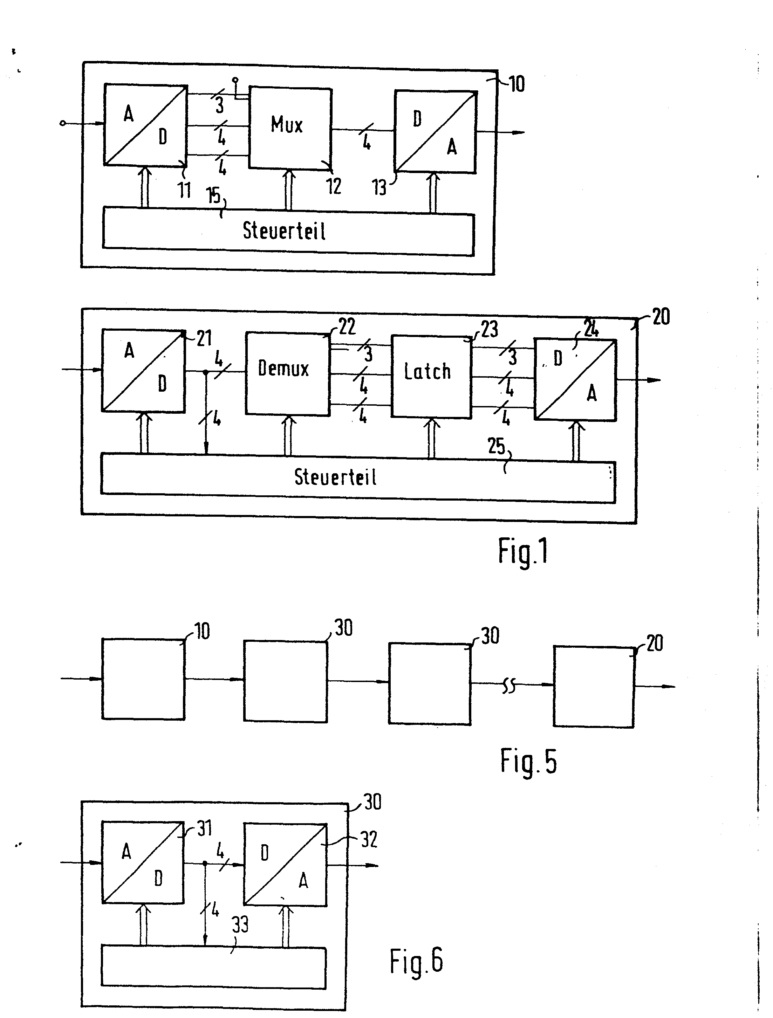

Fig. 2   zeigt ein weiteres Ausführungsbeispiel, welches
         eine Erweiterung des Ausführungsbeispiels von
         Fig. 1 darstellt.

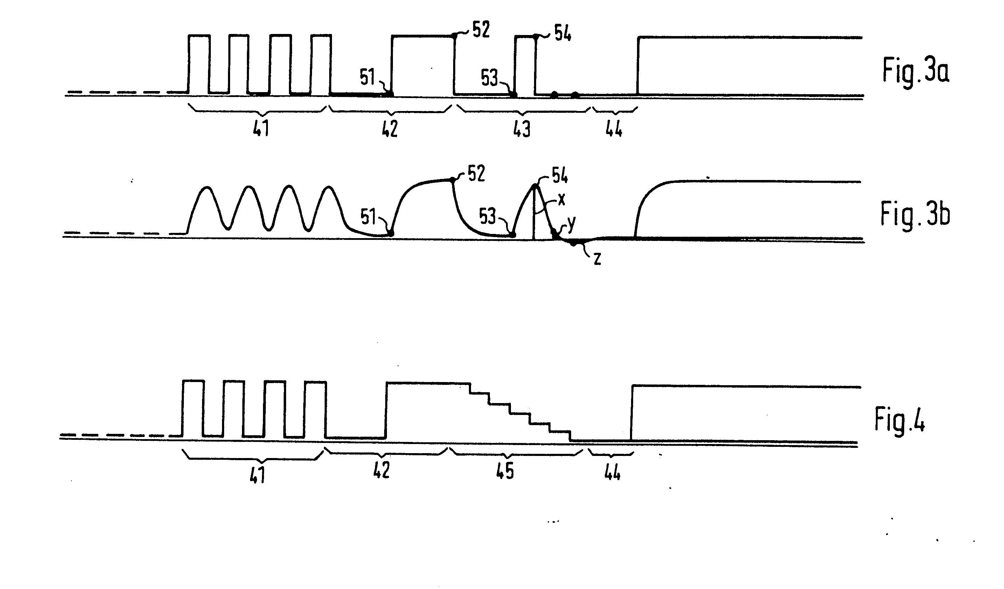

Fig. 3   zeigt ein Beispiel eines Kontrollsignals am Ein-
         gang (Fig. 3a) und am Ausgang (Fig. 3b) einer
         Übertragungsstrecke oder eines Speichermediums
         in einem erfindungsgemäßen System.

Fig. 4   zeigt ein weiteres Beispiel eines Kontrollsi-
         gnals.

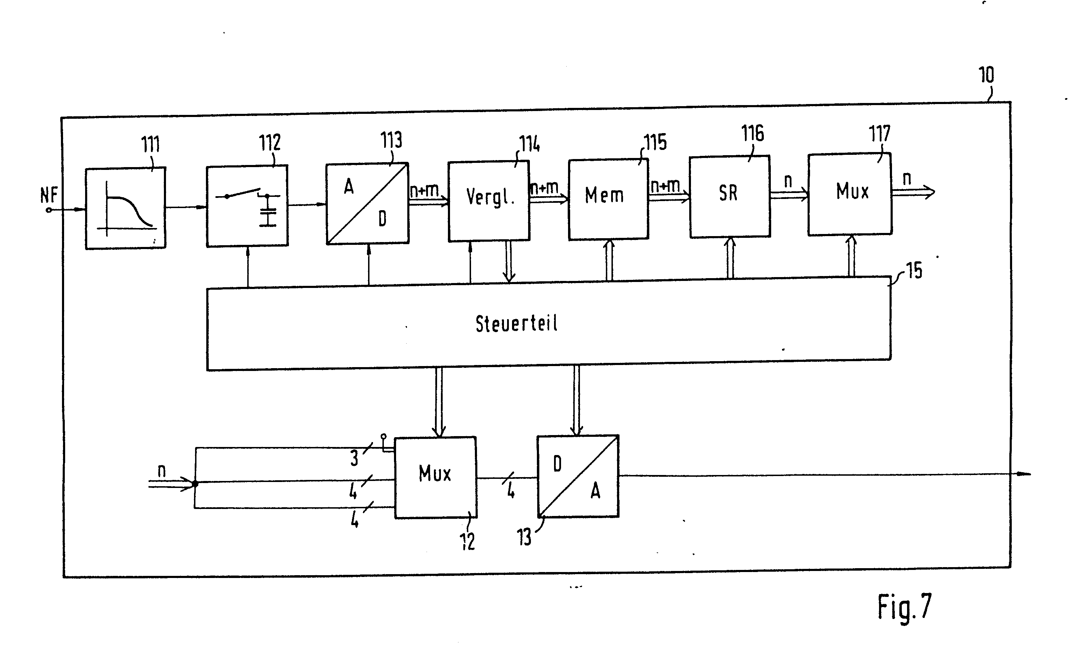

Fig. 5   zeigt in vereinfachter Form ein Ausführungsbeispiel eines erfindungsgemäßen Systems mit einem
         Eingangsteil, mehreren Zwischenstufen und einem
         Ausgangsteil.

Fig. 6   zeigt als Ausführungsbeispiel das Blockschalt-

G.G.Gassmann 113/112-10/9-2/1

bild einer erfindungsgemäßen Zwischenstufe
für ein System entsprechend Fig. 5.

Fig. 7   zeigt das Blockschaltbild eines weiteren Ausführungsbeispiels eines Eingangsteils eines
erfindungsgemäßen Systems.

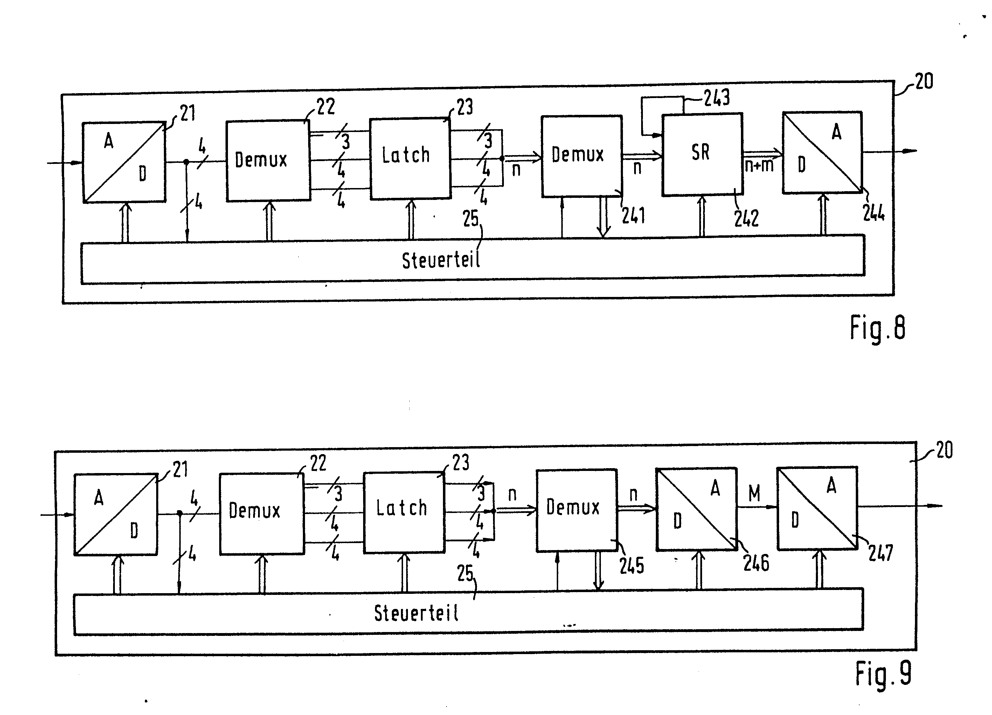

Fig. 8   zeigt ein Blockschaltbild eines Ausgangsteils
für ein System mit einem Eingangsteil nach
Fig. 7.

Fig. 9   zeigt ein weiteres Blockschaltbild eines Ausgangsteils für ein System mit einem Eingangsteil nach Fig. 7.

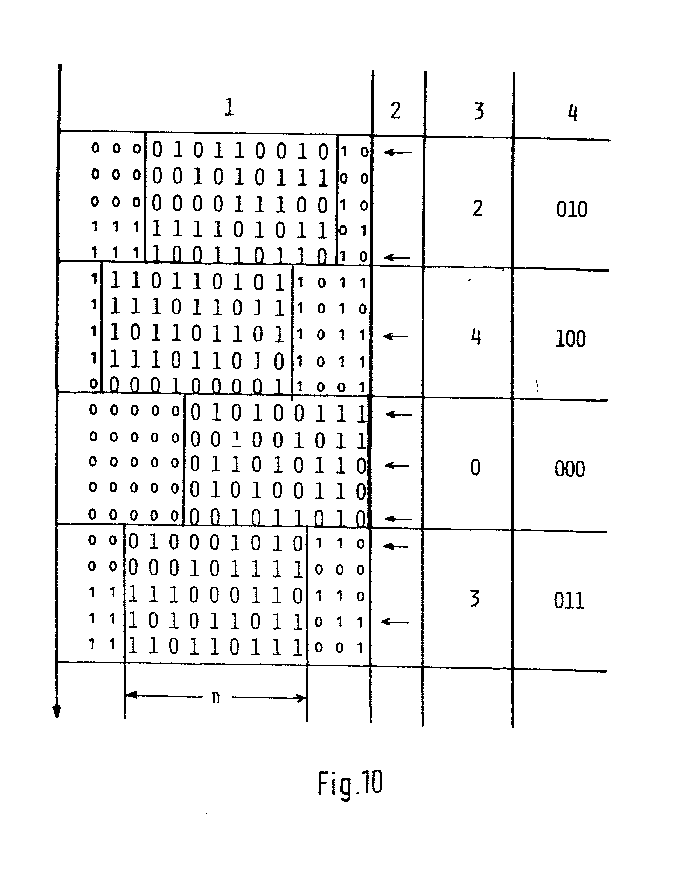

Fig. 10 zeigt in tabellenartiger, vereinfachter Form
die Bildung von Exponenten und Mantissen im
Eingangsteil nach Fig. 7.

Fig. 1 zeigt ein Ausführungsbeispiel, in dem die Grundidee der Erfindung klar ersichtlich wird. Das gesamte
System umfaßt außer einem Eingangsteil 10 und einem
Ausgangsteil 20 noch eine Übertragungsstrecke oder ein
Speichermedium. In diesem, wie auch in den folgenden
Ausführungsbeispielen wird eine Übertragungsstrecke oder
ein Speichermedium unberücksichtigt gelassen. Die hieran zu stellenden Forderungen ergeben sich ohne weiteres
aus der Beschreibung von Eingangs- und Ausgangsteil.

Der Eingangsteil 10 besteht aus einem Analog-Digital-
Wandler 11, einem Multiplexer 12, einem Digital-Analog-
Wandler 13 und einem Steuerteil 15. Der Wandler 11 wandelt jeden Analogwert in ein (im Beispiel 11-stelliges)

G.G.Gassmann 113/112-10/9-2/1

Datenwort. Dieses Datenwort wird in eine meistsignifikante 3-stellige Bitgruppe und zwei weitere 4-stellige Bitgruppen zerlegt. Die 3-stellige Bitgruppe wird durch Anfügen einer Null an der letzten, geringstsignifikanten Stelle zu einer ebenfalls 4-stelligen Bitgruppe erweitert. Diese drei Bitgruppen werden vom Multiplexer 12 der Reihe nach durchgeschaltet und liegen dann am Eingang des Digital-Analog-Wandlers 13 an. Am Ausgang des Wandlers 13, der auch der Ausgang des Eingangsteils 10 ist, ergibt sich damit ein pulsamplitudenmoduliertes Signal. Die meistsignifikante Bitgruppe ergibt einen Impuls, welcher, dem repräsentierten Wert entsprechend,eine von acht verschiedenen Amplitudenstufen aufweisen kann. Die weiteren Bitgruppen ergeben je einen Impuls, welcher eine von 16 Amplitudenstufen aufweisen kann. Der Steuerteil 15 steuert den zeitlichen Ablauf im Eingangsteil 10. Aufbau und Wirkungsweise des Steuerteils 15 sind weitgehend abhängig von den zu verarbeitenden Analogwerten. Soll ein kontinuierliches Analogsignal verarbeitet werden, welches nicht mit einem äußeren Takt synchronisiert ist, so wird der Steuerteil beispielsweise aus einem Taktgenerator für den Multiplexer 12 und den Wandler 13 bestehen und weiter einen Frequenzteiler enthalten, welcher durch Dreiteilung dieser Taktfrequenz den Takt für den Wandler 11 bestimmt. Sind die Analogwerte mit einem äußeren Takt verkoppelt, so dient der Steuerteil 15 der Synchronisation mit diesem Takt.

Der Ausgangsteil 20 besteht aus einem Analog-Digital-Wandler 21, einem Demultiplexer 22, einem Zwischenspeicher 23, einem Digital-Analog-Wandler 24 und einem Steuerteil 25. Im Analog-Digital-Wandler 21 wird das ankommende, pulsamplitudenmodulierte Signal wieder in die

G.G.Gassmann 113/112-10/9-2/1

4-stelligen Bitgruppen zurückgewandelt. Die Verstärkung eines vorangehenden Verstärkers und die Referenzspannung des Wandlers 21 müssen entsprechend eingestellt werden. Da nur 16 Amplitudenstufen auftreten, bei der meistsignifikanten Bitgruppe sogar nur 8 noch gröbere, ist die korrekte Rückgewinnung der einzelnen Bitgruppen auch bei geringen Störungen auf der Übertragung bzw. bei der Speicherung noch möglich. Durch den Demultiplexer 22 mit nachfolgendem Zwischenspeicher 23 werden wieder die ursprünglichen 11-stelligen Datenwörter gebildet. Der Digital-Analog-Wandler 24 stellt die ursprünglichen Analogwerte wieder her, wobei im wesentlichen nur der Quantisierungsfehler auftritt. Der Steuerteil 25 muß zunächst die Synchronisation zwischen Eingangsteil 10 und Ausgangsteil 20 herstellen. Möglichkeiten zur Taktrückgewinnung aus pulsförmigen Signalen sind genügend bekannt. Auch kann der Takt auf andere Weise, etwa durch eine getrennte Taktleitung, durch Synchronismus mit der Netzfrequenz oder mit der Zeilen- oder Bildfrequenz einer Fernsehübertragungsstrecke, vorgegeben sein.

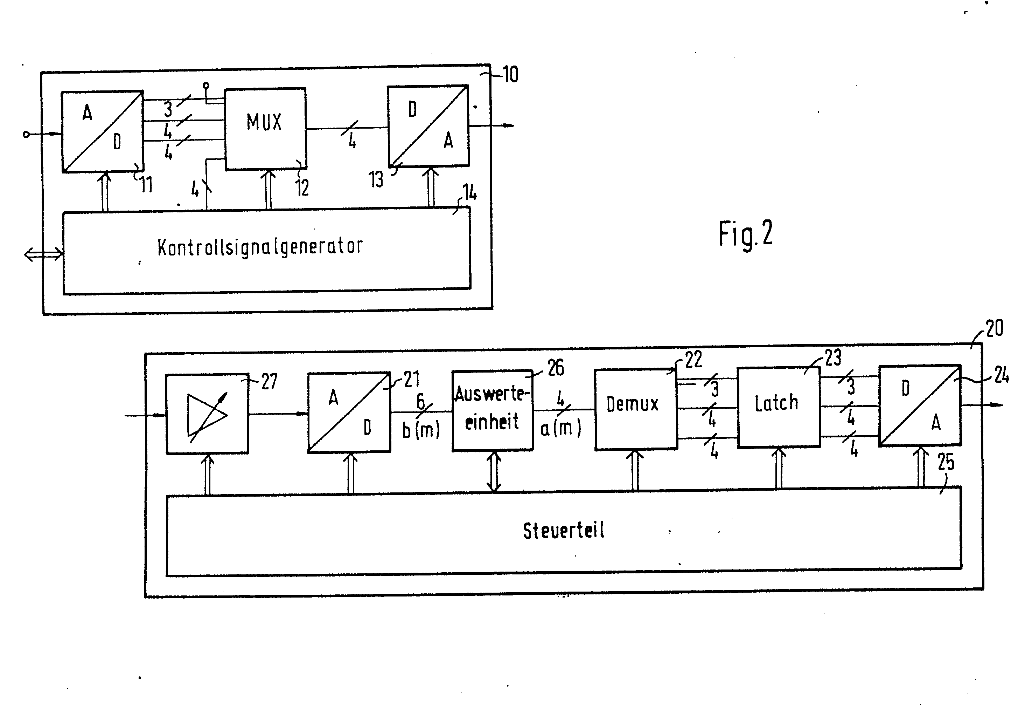

Anhand von Fig. 2 sollen weitere Ausführungsbeispiele erfindungsgemäßer Eingangsteile 10 und Ausgangsteile 20 näher erläutert werden:

Der Analog-Digital-Wandler 21 im Ausgangsteil 20 kann so aufgebaut sein, daß er doppelt oder wie in Fig. 2 gezeigt viermal so viel Amplitudenstufen auflösen kann, wie vom Digital-Analog-Wandler 13 im Eingangsteil 10 erzeugbar sind. Es entstehen 6-stellige Bitgruppen entsprechend 64 aufgelösten Amplitudenstufen, die in einer Auswerteeinheit 26 in die ursprünglichen, 4-stelligen Bitgruppen zurückgewandelt werden. Bei einem fest auf-

G.G.Gassmann 113/112-10/9-2/1

gebauten System mit unveränderlichen Eigenschaften können in der Auswerteeinheit 26 Tabellen abgespeichert
sein, mit deren Hilfe jede Bitgruppe aus den vorangegangenen Bitgruppen und dem Augenblickswert am Ausgang
des Wandlers 21 berechnet werden kann.

Eine begrenzte Bandbreite hat Laufzeitverzögerungen zur
Folge und diese wiederum führen dazu, daß an jeder Stelle
der Augenblickswert zu einem bestimmten Zeitpunkt auch
von den Augenblickswerten vorangegangener Zeitpunkte abhängt. Betrachtet man die vom Takt gegebenen Zeitpunkte
m, m-1, m-2 und m-3, bezeichnet man die Istwerte, wie
sie sich am Eingang der Auswerteeinheit 26 ergeben mit
b(m) und die Sollwerte, wie sie sich am Ausgang der Auswerteeinheit 26 ergeben sollen mit a(m), so gilt folgende Beziehung:

$$b(m) = x \cdot a(m-1) + y \cdot a(m-2) + z \cdot a(m-3) + \ldots \qquad (GL.1)$$

Dabei sind die Koeffizienten x, y und z charakteristisch
für die, hier angenommenermaßen als konstant angesehenen,
Systemeigenschaften. Da die Koeffizienten für den Einfluß
weiter zurückliegender Werte immer kleiner werden, wird
hier nach drei Summanden abgebrochen. Diese Beziehung
läßt sich umformen in

$$a(m-1) = \frac{1}{x} \cdot b(m) - \frac{y}{x} \cdot a(m-2) - \frac{z}{x} \cdot a(m-3). \qquad (GL.2)$$

Die 64 möglichen Werte von b(m)/x, die 16 möglichen Werte für y·a(m-2)/x und die 16 möglichen Werte für
z·a(m-3)/x können aus Tabellen abrufbar gemacht werden,
wodurch die Bestimmung neuer Werte a(m-1) auf die Adressierung von Tabellen, eine Addition und eine anschließen-

0115319

G.G.Gassmann 113/112-10/9-2/1

de Rundung zurückgeführt ist. Auf diese Weise erfüllt
die Auswerteeinheit die Funktion eines Transversalfilters.

Bei einem nichtlinearen System können auch in entsprechender Weise Tabellen in der Auswerteeinheit enthalten sein,
mit deren Hilfe die Auswerteeinheit die Funktion eines
Entzerrers erfüllt.

Wird das System erst bei Bedarf durch Anschluß eines
Eingangsteils 10 und eines Ausgangsteils 20 an eine
Übertragungsstrecke oder an ein Speichermedium gebildet
oder sind zeitliche Änderungen der Systemeigenschaften zu
erwarten, etwa bei Übertragungsstrecken mit schwankender
Bandbreite, so ist es sinnvoll, Kontrollsignale einzusetzen, mit deren Hilfe die Auswerteeinheit 26 die Systemeigenschaften in regelmäßigen Abständen selbst bestimmen
kann. Hierzu wird der einfache Steuerteil 15 im Eingangsteil 10 durch einen Kontrollsignalgenerator 14 ersetzt.
Dieser Kontrollsignalgenerator hat mehrere Aufgaben zu
erfüllen. Das vom Eingangsteil 10 abgegebene Datensignal
muß in Datenblöcke gegliedert werden, damit Pausen entstehen, in die ein Kontrollsignal eingefügt werden kann.
In diese Pausen muß ein Kontrollsignal eingefügt werden,
aus dem die Auswerteeinheit 26 im Ausgangsteil 20 durch
Vergleich mit dem bekannten Sollverlauf eine Zuordnungsvorschrift für die Bitgruppen des höher aufgelösten Datenstroms zu den Bitgruppen der ursprünglichen Auflösung
gewinnen kann. Wenn nicht im Eingangsteil 10 noch ein,
vorwiegend digital aufgebauter Zwischenspeicher eingebaut ist, müssen die zu verarbeitenden Analogwerte
bereits Pausen enthalten. Dies muß entweder vom Kontrollsignalgenerator 14 veranlaßt werden oder, wenn dies von
außen gesteuert ist, muß der Kontrollsignalgenerator 14

G.G.Gassmann 113/112-10/9-2/1

mit der äußeren Steuerung synchronisiert werden. Das
Kontrollsignal selbst wird im gezeigten Beispiel über
weitere Eingänge des Multiplexers 12 zugeschaltet. Der
Kontrollsignalgenerator 14 übernimmt die gesamte Steuerung im Eingangsteil 10.

Das Kontrollsignal kann aus verschiedenen Abschnitten
bestehen:

Eine regelmäßige Impulsfolge kann zur Synchronisierung
zwischen Eingangsteil 10 und Ausgangsteil 20 verwendet
werden.

Ein Sprungsignal (d.h. ein Signal, das zunächst mindestens bis zum Abklingen von Einschwingvorgängen auf der
niedrigsten Amplitudenstufe liegt, dann auf die höchste
Amplitudenstufe springt und dort wieder mindestens bis
zum Abklingen von Einschwingvorgängen verweilt) kann im
Ausgangsteil 20 zur Bestimmung der Systemverstärkung
und eines etwaigen Gleichspannungsanteils verwendet werden. Damit kann im Ausgangsteil 20 über die Auswerteeinheit 26 und den Steuerteil 25 ein einstellbarer Vorverstärker 27 eingestellt werden.

Mit einem kurzen Einzelimpuls zwischen zwei ausreichend
langen Pausen können die Filterkoeffizienten eines ausgangsseitigen Transversalfilters bestimmt werden.

Mit einer Rampenfunktion können Nichtlinearitäten erfaßt
und die für eine Entzerrung erforderlichen Koeffizienten
bestimmt werden.

Fig. 3 zeigt ein Beispiel eines Kontrollsignals. Dabei

G.G.Gassmann 113/112-10/9-2/1

ist in Figur 3a das Kontrollsignal dargestellt, wie es
vom Eingangsteil 10 abgegeben wird und in Figur 3b die
infolge einer Bandbegrenzung auftretende verzerrte Form,
wie sie am Ausgangsteil 20 eintrifft. Die regelmäßige
Impulsfolge (Burst) 41 dient in an sich bekannter Weise
zur Synchronisation des Ausgangsteils 20. Das Sprungsignal 42 mit jeweils längerer Verweildauer bei high und
low (um Einschwingvorgänge abklingen zu lassen) dient mit
den Meßpunkten 51 und 52 im Ausgangsteil 20 zur Ermittlung der Maximalamplitude.

Die Filterkoeffizienten des Transversalfilters (x,y,z
nach Gl.1) können mittels des Einzelimpulses 43 wie folgt
ermittelt werden:

Bei begrenzter Bandbreite ist der Sprung vom Meßpunkt 53
zu Meßpunkt 54 nicht gleich der Maximalamplitude, sondern
gleich x, weil infolge der vorangegangenen Nullwerte in
der Beziehung

$$b(m)=x \cdot a(m-1)+y \cdot a(m-2)+z \cdot a(m-3) \qquad (Gl.3)$$

die Werte a(m-2) und a(m-3) gleich Null sind und in
diesem Sonderfall also

$$b(m)=x \cdot a(m-1) \qquad (Gl.4)$$

ist, wobei vom Eingangsteil 10 natürlich Maximalamplitude
gesendet wird, also a(m-1)=1 ist und somit b(m)=x ist.
Im Ausgangsteil 20 ist die Amplitude beim Meßpunkt 54
also unmittelbar gleich x. Einen Abtastwert später wird
vom Eingangsteil 10 wieder Null gesendet, so daß jetzt
wegen a(m-1)=0 und a(m-3)=0

G.G.Gassmann 113/112-10/9-2/1

$$b(m) = x \cdot a(m-1) + y \cdot a(m-2) + z \cdot a(m-3) = x \cdot 0 + y \cdot 1 + z \cdot 0 = y \qquad (Gl.5)$$

ist. Noch einen Abtastwert später ist b(m)=z. Man kann also bei diesem Kontrollsignal im Ausgangsteil 20 direkt die Filterkoeffizienten x, y, z gewinnen, die man zur Auswertung, d.h. zur Berechnung des echten, unverzerrten Wertes a(m-1) aus dem letzten empfangenen Wert b(m) und den vorausgehenden, bereits auf die echten Werte a(m-2) und a(m-3) umgerechneten Werte unter Zuhilfenahme der Beziehung

$$a(m-1) = \frac{1}{x} \cdot b(m) - \left[\frac{y}{x} \cdot a(m-2) + \frac{z}{x} \cdot a(m-3)\right] \qquad (Gl.2a)$$

verwendet. Um in dieser Formel für den ersten übertragenen Datenwert (bei dem ja keine vorausgegangenen Werte a(m-2) und a(m-3) existieren) Nullbeträge für a(m-2) und a(m-3) zu erhalten, dient ein Leersignal 44 vor dem Datensignal.

In Fig. 3b ist das Kontrollsignal entsprechend Fig. 3a am Ausgang eines bandbegrenzten Speichermediums bzw. einer bandbegrenzten Übertragungsstrecke dargestellt. Man erkennt die Verzerrung und die dadurch ermittelbaren Werte x, y, z. Dabei ist z hier ein sehr geringer negativer Wert (negativ infolge Überschwingen).

Fig. 4 zeigt ein anderes Kontrollsignal für einen anderen Anwendungsfall, bei dem keine linearen Verzerrungen durch Bandbegrenzungen auftreten, bei dem aber nichtlineare Verzerrungen zu erwarten sind. Hier wird anstelle des Einzelimpulses 43 eine Rampenspannung (Treppenspannung 45) gesendet. Im Ausgangsteil 20 wird die verzerrt eingehende Rampenspannung mit den Sollwerten verglichen. Aus den Abweichungen werden amplitudenabhängige Korrekturinformationen gebildet und gespeichert. Die jeweilige ampli-

G.G.Gassmann 113/112-10/9-2/1

tudenabhängige Korrekturinformation wird bei der anschließenden Auswertung von Bitgruppen zum zunächst erhaltenen Wert addiert (oder von diesem subtrahiert), so daß somit ein selbstadaptierendes Entzerrungssystem entsteht.

Bei einem Anwendungsfall, bei dem lineare und nichtlineare Verzerrungen auftreten, kann man schließlich sowohl eine Rampenspannung 45 als auch einen Einzelimpuls 43 zur Ermittlung der Transversalfilterparameter verwenden.

Die Auswerteeinheit 26 hat im wesentlichen zwei Aufgaben. Zum einen müssen die Systemeigenschaften regelmäßig mit Hilfe des Kontrollsignals kontrolliert und daraus Tabellen für die Auswertung erstellt werden und zum andern muß der laufende Datenstrom ständig bearbeitet werden. Es ist vorteilhaft, die Auswerteeinheit 26 entsprechend diesen beiden Aufgaben in zwei Teileinheiten aufzuteilen. Eine dieser Teileinheiten wertet dann regelmäßig die Kontrollsignale aus und erstellt Tabellen, mit denen die andere Teileinheit unter Zuhilfenahme dieser Tabellen die Zuordnung zwischen den Bitgruppen des höher aufgelösten Datenstroms und den Bitgruppen mit der ursprünglichen Auflösung durchführt. Dazu müssen die Tabellen doppelt vorhanden sein; ihre Zuordnung zu den beiden Teileinheiten muß umkehrbar sein.

Die Vorteile eines erfindungsgemäßen Systems kommen besonders dann zur Geltung, wenn zwischen Eingangsteil 10 und Ausgangsteil 20 nicht nur eine Übertragungsstrecke oder ein Speichermedium vorhanden ist, sondern mehrere und wenn dazwischen jeweils das Signal regeneriert werden soll. Ein solches System mit einem Eingangsteil 10, einem Aus-

G.G.Gassmann 113/112-10/9-2/1

gangsteil 20 und mehreren Zwischenstufen 30 ist in Fig. 5 gezeigt. Die Übertragungswege und/oder Speichermedien sind dabei vereinfacht durch die verbindenden Pfeile dargestellt. Dabei genügt es, in den Zwischenstufen 30 nur die Amplitudenstufen festzustellen und zu regenerieren, d.h., nur das pulsamplitudenmodulierte analoge Datensignal zu regenerieren.

Fig. 6 zeigt, wie eine solche Zwischenstufe 30 im einfachsten Fall aufgebaut sein kann. Auf einen Analog-Digital-Wandler 31 folgt unmittelbar ein Digital-Analog-Wandler 32. Ein Steuerteil 33 synchronisiert auf bekannte Weise die Zwischenstufe 30 mit dem Eingangsteil 10 oder einer vorangegangenen Zwischenstufe. Bei Bedarf kann die Zwischenstufe 30 auch durch eine Auswerteeinheit, einen Kontrollsignalgenerator und einen einstellbaren Vorverstärker erweitert werden.

Anhand der Figuren 7 bis 10 wird gezeigt, wie durch zusätzliche Maßnahmen der bei der Übertragung oder Speicherung eines Tonsignals auftretende Bedarf an Übertragungsbandbreite oder Übertragungszeit bzw. Speicherkapazität weiter deutlich verringert werden kann. Die zu übertragenden und/oder zu speichernden Amplitudenwerte werden in einer noch näher zu erklärenden Weise im Eingangsteil 10 in eine Folge n-stelliger digitaler Datenwörter umgewandelt und im Ausgangsteil 20 aus dieser Folge zurückgewonnen. Die n-stelligen digitalen Datenwörter werden zweckmäßigerweise so weiterverarbeitet, wie in einem der schon beschriebenen Ausführungsbeispiele. im folgenden werden nur noch diejenigen Baugruppen und ihre Funktionen beschrieben, die an die Stelle des Analog-Digital-Wandlers 11 im Eingangsteil 10

G.G.Gassmann 113/112-10/9-2/1

und des Digital-Analog-Wandlers 24 im Ausgangsteil 20 treten sowie die zusätzlichen Funktionen, die die Steuerteile 15 (oder 14) und 25 mit übernehmen müssen.

Anhand von Fig. 7 wird der Signal- und Datenweg im Eingangsteil eines solchen Systems beschrieben. Ein ankommendes Tonsignal NF wird in einem Tiefpaß 111 bandbegrenzt und von einem Abtast-Halte-Glied 112 mit einer dem Abtasttheorem genügenden Taktfrequenz abgetastet und einem nachfolgenden Analog-Digital-Wandler 113 zugeführt. Der Wandler 113 ist so ausgelegt, daß er den gesamten Lautstärkebereich erfaßt und daß die Quantisierungsstufen im gesamten Bereich den Quantisierungsstufen entsprechen, die für den leisesten Teillautstärkebereich vorgesehen sind. An seinem Ausgang treten digitale Datenwörter mit n+m Stellen auf. Die Figuren zeigen Beispiele, bei denen digitale Datenwörter in paralleler Form weitergegeben werden. Eine Weitergabe in serieller Form mit entsprechend höherem Takt ist ebenfalls möglich. Die im Wandler 113 entstehenden Digitalwerte werden durch einen Vergleicher 114 an einen Speicher 115 weitergegeben. Der Vergleicher 114 stellt bei jedem Digitalwert die Größenordnung fest und ordnet diesem einen Exponenten zu, welcher mit dem Exponenten des bisher ermittelten Maximalwerts verglichen wird. Der größere dieser beiden Exponenten wird festgehalten, der Digitalwert wird unverändert an den Speicher 115 weitergegeben. Im Speicher 115 wird eine vorgegebene Anzahl von Digitalwerten zu einem Datenblock zusammengefaßt. Die Aufteilung der Digitalwerte in Exponent und Mantisse sowie die Bildung von Datenblöcken wird weiter unten anhand von Fig. 10 näher erläutert. Die Digitalwerte im Speicher 115 werden nach Bildung eines Datenblocks an ein Schie-

G.G.Gassmann 113/112-10/9-2/1

beregister 116 weitergegeben. Die Datenblöcke können mit
derselben Taktfrequenz wieder aus dem Speicher ausgelesen werden, mit der sie eingeschrieben wurden. Sie können aber auch blockweise sehr viel schneller ausgelesen
werden. Dies ist z.B. dann sinnvoll, wenn die Übertragung in der Austastlücke eines Fernsehsignals erfolgen
soll. Im Schieberegister 116 wird jeder Digitalwert so
verschoben, daß die n-stellige Mantisse die ersten oder
die letzten Stellen einnimmt. Diese Stellen werden an
einen Multiplexer 117 weitergegeben. Der Multiplexer 117
schaltet wahlweise die vom Schieberegister 116 kommenden
Daten oder vom Steuerteil 15 kommende Zusatzzeichen an
den Ausgang durch. Das Umschalten des Multiplexers 117
wie auch die übrigen Vorgänge im Eingangsteil werden von
diesem Steuerteil 15 gesteuert. Eines der vom Steuerteil
15 über den Multiplexer 117 auf den Ausgang gegebenen
Zusatzzeichen, die auch in Form n-stelliger digitaler
Datenwörter vorliegen müssen, stellt den Exponenten für
den nachfolgenden oder vorausgegangenen Datenblock dar.
Wird der Exponent erst nach dem Datenblock übertragen,
so müssen die Daten zur Rückumformung im Ausgangsteil
erst zwischengespeichert werden, bis der Exponent übertragen ist. Dort müßte dann ein zusätzlicher Speicher
vorhanden sein. Der jeweilige Exponent wird deshalb vorzugsweise  v o r  dem jeweiligen Datenblock übertragen.
Weitere vom Steuerteil 15 über den Multiplexer 117 an
den Ausgang gegebene Zusatzzeichen können Synchronisierzeichen sein. Beim oben genannten Beispiel der Übertragung in der Austastlücke eines Fernsehsignals können
Synchronisierzeichen fehlen, da diese vom Fernsehsignal
selbst geliefert werden.

Anhand der Figur 8 wird der Ausgangsteil eines solchen

G.G.Gassmann 113/112-10/9-2/1

Systems weiter erläutert. Die Mantissen eines Datenblocks kommen im zeitlichen Wechsel mit den Zusatzzeichen als n-stellige Digitalzahlen an den Eingang eines
Demultiplexers 241, der in Umkehrung zur Wirkungsweise
des Multiplexers 117 Mantissen und Zusatzzeichen voneinander trennt. Die Mantissen werden in ein Schieberegister
242 weitergegeben und dort in Umkehrung der Wirkungsweise des Schieberegisters 116 im Eingangsteil wieder in
Digitalwerte mit der ursprünglichen Stellenzahl n+m zurückgewandelt. Eine Verbindung 243 führt vom Ausgang der
ersten Stelle auf den Eingang der ersten Stelle zurück.
Dem Schieberegister 242 nachgeschaltet ist ein Digital-
Analog-Wandler 244, welcher das ursprüngliche Tonsignal
wieder herstellt. Das Steuerteil 25 steuert den gesamten
zeitlichen Ablauf des Ausgangsteils.

Fig. 9 zeigt eine andere Ausführungsform eines Ausgangsteils, bei dem ein Gleitkomma-D/A-Umsetzer eingesetzt
ist, wie er in der deutschen Zeitschrift "Elektronik"
in der Ausgabe vom 12.2.1982 (Heft 3) auf den Seiten 78
bis 80 von G.Heinle vorgestellt wird. Mit einem solchen
Umsetzer ist es möglich, einen aus einem Exponenten und
einer Mantisse bestehenden Digitalwert in einen Analogwert umzusetzen.

Einem Demultiplexer 245, der dem Demultiplexer 241 im
Beispiel entsprechend Fig. 8 entspricht, folgt ein Digital-Analog-Wandler 246, welcher einen Spannungswert M
bildet, der der Mantisse des jeweiligen Digitalwerts
analog ist. Dieser Spannungswert M wird als Referenzspannung einem weiteren Digital-Analog-Wandler 247 zugeführt.
Dessen digitaler Eingang wird von einem aus dem Exponenten gebildeten Wert angesteuert. Am Ausgang ist dann

G.G.Gassmann 113/112-10/9-2/1

wieder der ursprüngliche Analogwert vorhanden. Näheres
hierzu kann dem erwähnten "Elektronik"-Artikel entnommen werden. Das Steuerteil 25 steuert den gesamten Ablauf.

Anhand von Fig. 10 wird die Bildung von Datenblöcken sowie die Aufteilung der Digitalwerte in Exponent und Mantisse, wie auch die Rückgewinnung der ursprünglichen Digitalwerte weiter erläutert. Der zeitliche Ablauf wird in
Tabellenform dargestellt. Die einzelnen Zeilen entsprechen aufeinanderfolgenden Zeitpunkten. Im gezeigten Beispiel sind jeweils fünf Zeilen, d.h. fünf Zeitpunkte, zu
einem Datenblock zusammengefaßt. Im realen Schaltungsaufbau umfaßt ein Datenblock z.B. 256 Digitalwerte, was bei
einer Abtastfrequenz von 12,8 kHz einem Zeitabschnitt
von 20 msec entspricht. Für höhere Qualitätsanforderungen
können auch kürzere Zeitabschnitte, etwa 10 oder 5 msec
zu einem Datenblock zusammengefaßt werden. In Fig. 10
sind die einzelnen Datenblöcke durch waagerechte Linien
voneinander getrennt. Die Tabelle umfaßt vier Spalten.
Spalte 1 zeigt die Digitalwerte, wie sie vom Analog-
Digital-Wandler 113 gebildet werden. Verwendet wird ein
Zweier-Komplement-Kode. Alle positiven Werte beginnen
mit einer "0", alle negativen Werte beginnen mit einer
"1". Je kleiner der jeweilige Wert ist, desto mehr der
nachfolgenden Stellen sind der Vorzeichenstelle gleich.
Die untereinander gleichen Stellen am Anfang können bis
auf eine weggelassen werden, wenn angegeben wird, wieviele Stellen weggelassen wurden. Die Angabe der weggelassenen Stellen entspricht dem Exponenten, die übriggebliebenen Stellen sind die Mantisse. Auch bei der verbleibenden Mantisse sind nicht unbedingt alle Stellen erforderlich. Es genügt, die Mantisse auf eine feste Stellenzahl n zu beschränken und die restlichen Stellen am

G.G.Gassmann 113/112-10/9-2/1

Ende der Mantisse wegfallen zu lassen. Da sowohl der ursprüngliche Stellenwert n+m, wie auch der Stellenwert der verbleibenden Mantisse n festliegen, ist es unerheblich, ob die Anzahl der am Beginn oder die Anzahl der am Ende wegfallenden Stellen angegeben wird. In Spalte 2 sind Markierungen, die auf diejenigen Digitalwerte hinweisen, bei denen innerhalb eines Datenblocks der größte Exponent auftritt. Daß mehrere Digitalwerte auftreten, bei denen dieser Exponent gleich groß ist, ist unerheblich, da nur dieser Exponent gesucht wird und nicht der Datenwert, bei welchem er in Erscheinung tritt. Ausgehend von dem so ermittelten Exponenten wird bei jedem Digitalwert des jeweiligen Datenblocks jeweils die gleiche Anzahl von führenden Stellen wie auch eine entsprechende Anzahl von Stellen am Ende unterdrückt. Dies geschieht im Schieberegister 116 durch eine entsprechende Verschiebung der gesamten Digitalzahl. Die verbleibenden Stellen sind in der Tabelle gegenüber den übrigen, wegfallenden Stellen hervorgehoben.In Spalte 3 ist jeweils als Dezimalzahl die Anzahl der am Ende wegfallenden Stellen angegeben. In Spalte 4 ist der zugehörige Binärwert genannt. Durch diese Zahlen liegt der Exponent des jeweiligen Datenblocks fest. Die Rückgewinnung des ursprünglichen Digitalwerts kann im Ausgangsteil etwa dadurch erfolgen, daß im Schieberegister 242 die jeweilige Mantisse linksbündig eingelesen und um so viele Stellen nach rechts verschoben wird, wie ursprünglich führende Stellen weggelassen wurden. Mittels der Verbindung 243 wird dafür gesorgt, daß die vorderste Stelle vor und nach dem Verschieben jeweils gleich ist, so daß alle führenden Stellen untereinander gleich sind. Die Ziffernfolge der hinten angefügten Stellen ist unerheblich; sie können sowohl auf einen

G.G.Gassmann 113/112-10/9-2/1

festen Wert eingestellt werden wie auch, der Einfachheit halber, vom vorangegangenen Digitalwert übernommen
werden.

Ein erfindungsgemäßes System kann in vorteilhafter Weise
verwendet werden, um in einem Fernsehübertragungssystem
einen zusätzlichen Tonkanal zur Verfügung zu stellen.
Dazu wird das Eingangsteil eines erfindungsgemäßen Systems an der Sendeseite und der Ausgangsteil an der Empfangsseite des Fernsehübertragungssystems hinzugefügt.
Ein zusätzliches Tonsignal kann dann zeitlich komprimiert
anstelle des Bildinhalts einer Zeile der Vertikalaustastlücke übertragen werden.

0115319

G.G.Gassmann 113/112-10/9-2/1


Bezugszeichenliste


| | | | |
|---|---|---|---|
| 10 | Eingangsteil | M | Spannungswert |
| 11 | Analog-Digital-Wandler | NF | Tonsignal |
| 12 | Multiplexer | 111 | Tiefpaß |
| 13 | Digital-Analog-Wandler | 112 | Abtast-Halte-Glied |
| 14 | Kontrollsignalgenerator | 113 | Analog-Digital-Wandler |
| 15 | Steuerteil | 114 | Vergleicher |
| 20 | Ausgangsteil | 115 | Speicher |
| 21 | Analog-Digital-Wandler | 116 | Schieberegister |
| 22 | Demultiplexer | 117 | Multiplexer |
| 23 | Zwischenspeicher | 241 | Demultiplexer |
| 24 | Digital-Analog-Wandler | 242 | Schieberegister |
| 25 | Steuerteil | 243 | Verbindung |
| 26 | Auswerteeinheit | 244 | Digital-Analog-Wandler |
| 27 | Vorverstärker | 245 | Demultiplexer |
| 30 | Zwischenstufe | 246 | Digital-Analog-Wandler |
| 31 | Analog-Digital-Wandler | 247 | Ditital-Analog-Wandler |
| 32 | Digital-Analog-Wandler | | |
| 33 | Steuerteil | | |
| 41 | regelmäßige Impulsfolge | | |
| 42 | Sprungsignal | | |
| 43 | Einzelimpuls | | |
| 44 | Leersignal | | |
| 45 | Rampenspannung | | |
| 51 | Meßpunkt | | |
| 52 | " | | |
| 53 | " | | |
| 54 | " | | |

- 1 -

G.G.Gassmann-G.Bertsch-G.Köhler I 113/112-10/9-2/1


Patentansprüche


1. System zur Übertragung und/oder Speicherung von Analogwerten mindestens bestehend aus einem Eingangsteil, einer Übertragungsstrecke oder einem Speichermedium für Analogsignale (beispielsweise einem Ton- oder Videobandgerät) und einem Ausgangsteil, wobei im Eingangsteil ein Analog-Digital-Wandler vorhanden ist, der jeden Analogwert in ein n-stelliges digitales Datenwort wandelt und wobei im Ausgangsteil ein Digital-Analog-Wandler vorhanden ist, der die n-stelligen digitalen Datenwörter in Analogwerte rückwandelt, d a d u r c h   g e k e n n - z e i c h n e t ,   daß der Eingangsteil (10) weiter enthält:

- einen Multiplexer (12), der jedes digitale Datenwort in zwei oder mehr (gleich oder ungleich lange) Bitgruppen zerlegt und so einen digitalen Datenstrom formt und

- einen Digital-Analog-Wandler (13), der jeder Bitgruppe einen Analogwert zuordnet und so den digitalen Datenstrom in ein analoges Datensignal entsprechend einer Pulsamplituden-Modulation umformt und

daß der Ausgangsteil (20) weiter enthält:

- einen Analog-Digital-Wandler (21), der das analoge Datensignal wieder in einen digitalen Datenstrom rück-

ZT/P2-Bs/Gn

12.12.1983                                                    - 2 -

wandelt,

- einen Demultiplexer (22) mit nachfolgendem Zwischenspeicher (23), der zusammengehörige, vom Analog-Digital-Wandler (21) gelieferte Bitgruppen wieder zu den
n-stelligen Datenwörtern zusammenfaßt und

- einen Steuerteil (25), mit dem der zeitliche Ablauf
synchron zum zeitlichen Ablauf im Eingangsteil (10)
gesteuert wird.


2. System nach Anspruch 1, dadurch gekennzeichnet, daß
der Multiplexer (12) im Eingangsteil (10) jedes digitale
Datenwort so in Bitgruppen zerlegt, daß eine meistsignifikante Bitgruppe und eine oder mehrere untereinander
gleich lange weitere Bitgruppen entstehen und daß die
meistsignifikante Bitgruppe eine geringere Stellenzahl
aufweist als die weiteren Bitgruppen.


3. System nach Anspruch 1 oder 2, dadurch gekennzeichnet,
daß der Analog-Digital-Wandler (21) im Ausgangsteil (20)
so aufgebaut ist, daß er mehr Amplitudenstufen unterscheiden kann als vom Digital-Analog-Wandler (13) im Eingangsteil (10) erzeugbar sind und damit das durch Übertragung und/oder Speicherung veränderte Datensignal in
einen Datenstrom mit höherer Auflösung rückwandelt und
daß dem Analog-Digital-Wandler (21) im Ausgangsteil (20)
eine Auswerteeinheit (26) folgt, welche jeder Bitgruppe
des höher aufgelösten Datenstroms eine Bitgruppe mit
der ursprünglichen Auflösung zuordnet.


4. System nach Anspruch 3, dadurch gekennzeichnet,
daß der Eingangsteil (10) zusätzlich einen Kontrollsignalgenerator (14) aufweist, welcher ein solches Kontrollsignal erzeugt, mit dem die Eigenschaften des Übertra-

G.G.Gassmann 113/112-10/9-2/1

gungswegs und/oder Speichermediums feststellbar sind und
mit dem das Datensignal in Datenblöcke gegliedert wird
und

daß die Auswerteeinheit (26) im Ausgangsteil (20) so
aufgebaut ist, daß sie regelmäßig das ankommende Kontrollsignal mit dessen bekanntem Sollverlauf vergleicht
und daraus eine Zuordnungsvorschrift für die Bitgruppen
des höher aufgelösten Datenstroms zu den Bitgruppen mit
der ursprünglichen Auflösung gewinnt.

5. System nach Anspruch 4, dadurch gekennzeichnet,
daß die Auswerteeinheit (26) so aufgebaut ist, daß sie
die Funktion eines in Digitaltechnik aufgebauten Transversalfilters erfüllt und daß sie die für dieses Transversalfilter erforderlichen Filterkoeffizienten durch Auswertung des ankommenden Kontrollsignals erhält und
daß der Kontrollsignalgenerator (14) so aufgebaut ist,
daß er ein solches Kontrollsignal erzeugt, welches zur
Auswertung im Ausgangsteil für die Bestimmung der Systemverstärkung und eines etwaigen Gleichspannungsanteils ein
Sprungsignal und für die Bestimmung der Filterkoeffizienten des Transversalfilters einen Einzelimpuls aufweist.

6. System nach Anspruch 4 oder 5, dadurch gekennzeichnet,
daß der Kontrollsignalgenerator (14) so aufgebaut ist,
daß er ein solches Kontrollsignal erzeugt, welches zur
Auswertung im Ausgangsteil für die Bestimmung der Nichtlinearität des Systems eine Rampenfunktion aufweist und
daß die Auswerteeinheit (26) so aufgebaut ist, daß sie die
Funktion eines in Digitaltechnik aufgebauten Entzerrers
erfüllt und daß sie die für die Entzerrung erforderlichen
Koeffizienten durch Auswertung des ankommenden Kontrollsignals erhält.

0115319

G.G.Gassmann 113/112-10/9-2/1

7. System nach einem der Ansprüche 4 bis 6, dadurch gekennzeichnet, daß der Kontrollsignalgenerator (14) so aufgebaut ist, daß er ein solches Kontrollsignal erzeugt, welches zur Synchronisierung eine regelmäßige Impulsfolge aufweist und daß die Auswerteeinheit (26) so aufgebaut ist, daß sie durch Auswertung der ankommenden Impulsfolge des Kontrollsignals ein Synchronisiersignal für den Steuerteil (25) bildet.

8. System nach einem der Ansprüche 4 bis 7, dadurch gekennzeichnet, daß die Auswerteeinheit (26) so in zwei Teileinheiten aufgeteilt ist, daß die erste Teileinheit die Zuordnung zwischen den Bitgruppen des höher aufgelösten Datenstroms und den Bitgruppen mit der ursprünglichen Auflösung durchführt und daß die zweite Teileinheit regelmäßig das Kontrollsignal auswertet und der ersten Teileinheit ein Zuordnungshilfsmittel in Form einer abgespeicherten Tabelle zur Verfügung stellt.

9. System nach einem der Ansprüche 1 bis 8, dadurch gekennzeichnet, daß zwischen Eingangs- (10) und Ausgangsteil (20) weitere Übertragungsstrecken und/oder Speichermedien vorhanden sind, daß eine oder mehrere Zwischenstufen (30) vorhanden sind und daß jede Zwischenstufe (30) so aufgebaut ist, daß das pulsamplitudenmodulierte analoge Datensignal regeneriert wird.

10. System nach einem der Ansprüche 1 bis 9, dadurch gekennzeichnet, daß das Eingangsteil (10) so aufgebaut ist, daß jeder Analogwert in einen aus einem Exponenten und einer n-stelligen Mantisse bestehenden Digitalwert umgesetzt wird, wobei der Exponent eine ganze Zahl zwischen 0 und einem Maximalwert m ist, daß zur Übertragung

G.G.Gassmann 113/112-10/9-2/1

bzw. Speicherung von Tonsignalen Eingangs- (10) und
Ausgangsteil (20) so aufgebaut sind, daß die Übertragung bzw. Speicherung blockweise erfolgt, wobei jeder
Datenblock die den Analogwerten eines kurzen Abschnitts
des Tonsignals entsprechenden Digitalwerte enthält, daß
alle Digitalwerte eines Datenblocks denselben Exponenten aufweisen, daß dieser Exponent nur einmal pro Datenblock übertragen bzw. gespeichert wird, daß dieser Exponent so gewählt ist, daß beim betragsmäßig größten
Wert des Datenblocks die Aufteilung in Exponent und Mantisse einer Gleitkommadarstellung entspricht und daß
sowohl der Exponent wie auch die Mantissen jeweils als
n-stelliges digitales Datenwort verarbeitet werden.

11. System nach Anspruch 10, dadurch gekennzeichnet,
daß der Eingangsteil (10) einen Steuerteil (15) enthält, der die Bildung von Datenblöcken so steuert, daß
der für einen Datenblock gültige Exponent vor den zugehörigen Mantissen übertragen bzw. gespeichert wird.

12. Fernsehübertragungssystem, bei dem ein Tonsignal
zeitlich komprimiert anstelle des Bildinhalts einer
Zeile der Vertikalaustastlücke übertragen wird, dadurch
gekennzeichnet, daß das Fernsehübertragungssystem zum
Übertragen des Tonsignals ein System nach einem der
Ansprüche 1 bis 11 enthält.

0115319

Fig.1

Fig.5

Fig.6

A / D  3  MUX  4  D / A

11  4  12  13  14

Kontrollsignalgenerator

Fig. 2

10

27  21  A / D  6 b(m)  Auswerte-einheit  4 a(m)  Demux  22  3 4 4  Latch  23  3 4 4  D / A  24

26  25

Steuerteil

20

Fig.3a

Fig.3b

Fig.4

G.G. Gassmann 113/112 - 10/9 - 2/7

0115319

0115319

Fig.7

Fig.8

Fig.9

0115319

G.G.Gassmann 113/112·10/9-2

| | 1 | 2 | 3 | 4 |
|---|---|---|---|---|

```
0 0 0 | 0 1 0 1 1 0 0 1 0 |1 0  ←
0 0 0 | 0 0 1 0 1 0 1 1 1 |0 0
0 0 0 | 0 0 0 0 1 1 1 0 0 |1 0          2    010
1 1 1 | 1 1 1 1 0 1 0 1 1 |0 1
1 1 1 | 1 0 0 1 1 0 1 1 0 |1 0  ←

1 |1 1 0 1 1 0 1 0 1 |1 0 1 1
1 |1 1 1 0 1 1 0 J 1 |1 0 1 0
1 |1 0 1 1 0 1 1 0 1 |1 0 1 1  ←       4    100
1 |1 1 1 0 1 1 0 J 0 |1 0 1 1
0 |0 0 0 1 0 0 0 1 |1 0 0 1

0 0 0 0 0 |0 1 0 1 0 0 1 1 1 |  ←
0 0 0 0 0 |0 0 1 0 0 1 0 1 1 |
0 0 0 0 0 |0 1 1 0 1 0 1 1 0 |  ←       0    000
0 0 0 0 0 |0 1 0 1 0 0 1 1 0 |
0 0 0 0 0 |0 0 1 0 1 1 0 1 0 |  ←

0 0 |0 1 0 0 0 1 0 1 0 |1 1 0  ←
0 0 |0 0 0 1 0 1 1 1 1 |0 0 0
1 1 |1 1 1 0 0 0 1 1 0 |1 1 0          3    011
1 1 |1 0 1 0 1 1 0 1 1 |0 1 1  ←
1 1 |1 1 0 1 1 0 1 1 1 |0 0 1
```

←———— n ————→

Fig.10

G.G.Gassmann 113/112-10